# EUROPÄISCHE PATENTANMELDUNG

(11) **EP 1 076 357 A1**
(43) Veröffentlichungstag der Anmeldung: **14.02.2001**
(21) Anmeldenummer: 99115834.6
(22) Anmeldetag: 11.08.1999
(51) Int. Cl.: H01L 21/00, H05K 13/04

(54) **Montagevorrichtung zur Herstellung microsystemtechnischer Produkte**

(71) Anmelder: SiMoTec GmbH, 82041 Oberhaching (DE)
(72) Erfinder: Pajonk, Joachim, 85635 Höhenkirchen (DE); Pogert, Jörg, 85521 Riemerling (DE); Kranich, Jochen, 82049 Pullach (DE); Fischer, Jakob, 82008 Unterhaching (DE)
(74) Vertreter: Hofstetter, Alfons J., Dr.rer.nat.

(57) **Zusammenfassung**

Die vorliegende Erfindung betrifft eine Montagevorrichtung 10, insbesondere eine vollautomatische Montagevorrichtung zur Herstellung mikrosystemtechnischer Produkte sowie für Montageaufgaben in der Halbleiterindustrie, mit einem Montagetisch 12, mindestens einem Materialtransportsystem 38 zum Transport der mit Bauteilen zu bestückenden Produkte, mindestens einem auf dem Montagetisch 12 angeordneten Transportsystem 16, 18 sowie mindestens eine zwischen dem Transportsystem 16, 18 angeordnete und bewegbare Bauteiltransporteinheit 34 mit mindestens einem Montagekopf 36, wobei die Bauteiltransporteinheit 34 bzw. -einheiten auf einem oder mehreren, mittels des Transportsystems 16, 18 parallel zur Richtung des Bauteiltransports verfahrbaren Portalen 20 angeordnet ist bzw. sind.

## Beschreibung

Die vorliegende Erfindung betrifft eine Montagevorrichtung, insbesondere eine vollautomatische Montagevorrichtung zur Herstellung mikrosystemtechnischer Produkte sowie für Montageaufgaben in der Halbleiterindustrie, mit einem Montagetisch, mindestens einem Materialtransportsystem zum Transport der mit Bauteilen zu bestückenden Produkte, mindestens einem auf dem Montagetisch angeordneten Transportsystem sowie mindestens eine zwischen dem Transportsystem angeordnete und bewegbare Bauteiltransporteinheit mit mindestens einem Montagekopf.

Derartige Montagevorrichtungen sind aus dem Stand der Technik bekannt. Bekannte gattungsgemäße Montagevorrichtungen lassen sich in drei Hauptkategorien einteilen: Bestücker zur Herstellung von Elektronikkomponenten, Montageautomaten für die Halbleiterindustrie und Laborgeräte für die Montage von Mustern mikrosystemtechnischer Demonstratoren. Derartige Montagevorrichtungen weisen aber vielfältige Nachteile insbesondere für die Herstellung von Mikrosystemen auf.

So sind sogenannte Bestücker auf Geschwindigkeit, d. h. auf einen möglichst hohen Durchsatz mit Bestückungszahlen bis zu 100.000 BE/h optimiert. Allerdings weisen sie den Nachteil auf, daß die Erhöhung der Geschwindigkeit mit einer reduzierten Montagegenauigkeit einher geht. Dies bedeutet, daß derartige Montagevorrichtungen nur für ein sehr begrenztes Spektrum an Bauteilen, Substraten und Montageprozessen Verwendung findet. Der Einsatz von Bestückern ist für die Montage von Mikrosystemen insbesondere aus Genauigkeitsgründen und mangels Flexibilität nicht möglich.

Demgegenüber sind Montageautomaten für die Halbleiterindustrie, sogenannte Die-Bonder auf Prozeßsicherheit, d. h. insbesondere auf eine relativ hohe Montagegenauigkeit, optimiert. Dabei ist eine Vielzahl von Die-Bonder-Ausführungen bekannt. Diese leiden aber an dem Nachteil, daß die angewandten und bisher bekannten Gestelltechniken in Kombination mit der zu realisierenden Montagebewegung entweder zu Lasten des Raumangebotes, d.h. der Beschränkung des auf einem Montagetisch verfügbaren Arbeitsraumes, gehen oder die Umrüstbarkeit beziehungsweise Konfigurierbarkeit und die Zugänglichkeit der Vorrichtung erschwert beziehungsweise beschränkt ist. Zudem ist eine ausreichende Steifigkeit der bekannten Die-Bonder-Aufbauten zur Erreichung hoher Montagegenauigkeiten bei entsprechend hohen Verfahrgeschwindigkeiten zur Erreichung hoher Durchsatzzahlen bisher nicht zufriedenstellend gelöst worden.

Bekannte Montagevorrichtungen aus der Elektronik- und Halbleiterindustrie genügen daher weder den kombinierten Anforderungen nach Montagepräzision bei gleichzeitig hohem Durchsatz, noch sind sie so flexibel gestaltet, daß eine rasche Umrüstbarkeit auf verschiedene Prozeßanforderungen und Materialpräsentationen erfolgen kann.

Es ist daher Aufgabe der vorliegenden Erfindung, eine gattungsgemäße Montagevorrichtung bereitzustellen, die einerseits eine hohe Montagepräzision, einen hohen Durchsatz sowie eine leichte Umrüstbarkeit gewährleistet.

Gelöst wird diese Aufgabe durch eine Montagevorrichtung mit den Merkmalen gemäß dem Anspruch 1.

Vorteilhafte Ausgestaltungen sind in den Unteransprüchen beschrieben.

Bei einer erfindungsgemäßen Montagevorrichtung ist eine Bauteiltransporteinheit beziehungsweise -einheiten auf einem oder mehreren, mittels eines Transportsystems parallel zur Richtung des Bauteiltransports verfahrbaren Portalen angeordnet.

Durch den Portalaufbau wird erfindungsgemäß erreicht, daß der Schwerpunkt des Transportsystems beziehungsweise aller bewegbaren Elemente der Montagevorrichtung relativ nahe an der Oberfläche eines Montagetisches liegt. Dadurch wird ein schwingungsarmer Aufbau der Montagevorrichtung erreicht, so daß eine hohe Montagegenauigkeit gewährleistet ist. Durch den Portalaufbau bleibt das Platzangebot auf dem Montagetisch erhalten, was für die Zugänglichkeit, Umrüstbarkeit und frei Konfigurierbarkeit vorteilhaft ist. Durch die erfindungsgemäße Anordnung von Portal und Materialtransportsystem ist es möglich, für den Bauteiltransport überwiegend nur den Montagekopf zu bewegen. Das Portal selbst führt dabei in bestimmten Montage-Modi nur eine kurze Ausgleichsbewegung durch, so daß relativ geringe Massen zu bewegen sind. Dadurch kann der Montagekopf mit größerer Geschwindigkeit bewegt werden, was wiederum zu größeren Durchsätzen führt. Weiterhin ist es möglich, größere Transportbewegungen durch Verfahren der Portale durchzuführen, so daß die gesamte zur Verfügung stehende Oberfläche des Montagetisches abgefahren werden kann, und somit eine hohe Bauteil- und Substratvariation ermöglicht wird.

In einer vorteilhaften Ausgestaltung der erfindungsgemäßen Montagevorrichtung besteht das Transportsystem aus einem Schienensystem mit einer ersten Schiene und einer zweiten Schiene, die zueinander parallel angeordnet sind. Durch das Schienensystem ist eine exakte Verfahrbarkeit des oder der Portale gewährleistet.

In einer weiteren vorteilhaften Ausgestaltung der erfindungsgemäßen Montagevorrichtung weist das Transportsystem mindestens einen Portalantrieb auf. Obgleich die Verwendung eines einzigen Portalantriebes bereits zu hervorragenden Ergebnissen im Bereich der Montagegenauigkeit und Montagegeschwindigkeit führt, kann die Verwendung zweier Portalantriebe, die jeweils an einer Seite des Portales angeordnet sind, zu noch höheren Montagegenauigkeiten und Montagegeschwindigkeiten führen. Dies liegt darin begründet, daß der Portalschwerpunkt in der Regel exzentrisch zum Antriebssystem sitzt beziehungsweise die Lage des Portalschwerpunktes aufgrund sich ständig ändernder Lastverhältnisse zeitlich variabel ist. Diese Exzentrität beziehungsweise zeitliche Variabilität kann zu Unwuchten mit entsprechendem negativem Einfluß auf die Montage- bzw. Positioniergenauigkeit des Portals führen. Durch die Verwendung von zwei geregelten Portalantrieben ist gewährleistet, daß der Portalschwerpunkt immer zwischen den Antrieben sitzt und somit keine exzentrische Lage auftreten kann. Durch die Verwendung von zwei geregelten Portalantrieben kann zusätzlich erreicht werden, daß abhängig von der aktuellen Position des Portalschwerpunktes die Antriebsregelung adaptiv ausgelegt wird, so daß eine hohe dynamische Steifigkeit des Portalaufbaues erreicht wird. Diese erfindungsgemäße Ausführungsform erlaubt es somit, die Positionierung noch exakter vorzunehmen.

In einer weiteren vorteilhaften Ausgestaltung der erfindungsgemäßen Montagevorrichtung ist das Transportsystem in der Tischebene des Montagetisches angeordnet. Dadurch ist gewährleistet, daß der Gesamtaufbau der Montagevorrichtung äußerst schwingungsarm ist.

In einer weiteren vorteilhaften Ausgestaltung der Erfindung ist es jedoch möglich, daß das Transportsystem über der Tischebene des Montagetisches angeordnet ist. Dadurch erhöht sich das Angebot an freiem Raum auf der Montagetischoberfläche, so daß eine größere Anzahl an unterschiedlichen Bauelementen oder ähnlichem angeordnet werden kann.

In einer weiteren vorteilhaften Ausgestaltung der erfindungsgemäßen Montagevorrichtung sind die Bewegungen mehrerer Portale untereinander synchronisierbar. Dadurch ist es möglich, die Produktionsgeschwindigkeit deutlich zu steigern. Durch eine dynamisch optimierte Synchronisierung mehrerer Portale in ihren jeweiligen Bewegungen kann eine deutliche Reduzierung der Maschinenschwingungen erreicht werden (dynamisches Wuchten), wodurch die Monategenauigkeit weiter gesteigert werden kann.

In einer weiteren vorteilhaften Ausgestaltung der Erfindung besteht der Montagekopf aus einem vertikal oder horizontal angeordneten Revolverkopf. Durch die Verwendung eines Revolverkopfes kann die Zahl der Transporthübe erheblich reduziert werden, wodurch die Transport-Nebenzeiten sinken und die Produktionsgeschwindigkeit wiederum erhöht werden kann.

In einer weiteren vorteilhaften Ausgestaltung der Erfindung ist es auch möglich, daß mehrere Portale übereinander angeordnet sind. Eine derartige Anordnung erhöht die Anzahl der Montageebenen, was wiederum zu einer Erhöhung der Produktionsgeschwindigkeit und zu einer noch größeren Flexibilität in Bezug auf die Anwendungsbereiche der erfindungsgemäßen Montagevorrichtung führt.

Weitere Einzelheiten, Merkmale und Vorteile der Erfindung ergeben sich aus der folgenden Beschreibung mehrerer zeichnerisch dargestellter Ausführungsbeispiele. Es zeigen:
- Figur 1: eine schematisch dargestellte erfindungsgemäße Montagevorrichtung mit einem Portal;
- Figur 2: eine schematisch dargestellte Montagevorrichtung gemäß Figur 1 mit dargestellten Portalantrieben;
- Figur 3: eine weitere Ausführungsform der erfindungsgemäßen Montagevorrichtung mit einem vertikal angeordneten Revolverkopf;
- Figur 4: eine weitere Ausführungsform der erfindungsgemäßen Montagevorrichtung mit einem horizontal angeordneten Revolverkopf; und
- Figur 5: eine weitere Ausführungsform der erfindungsgemäßen Montagevorrichtung mit zwei Portalen.

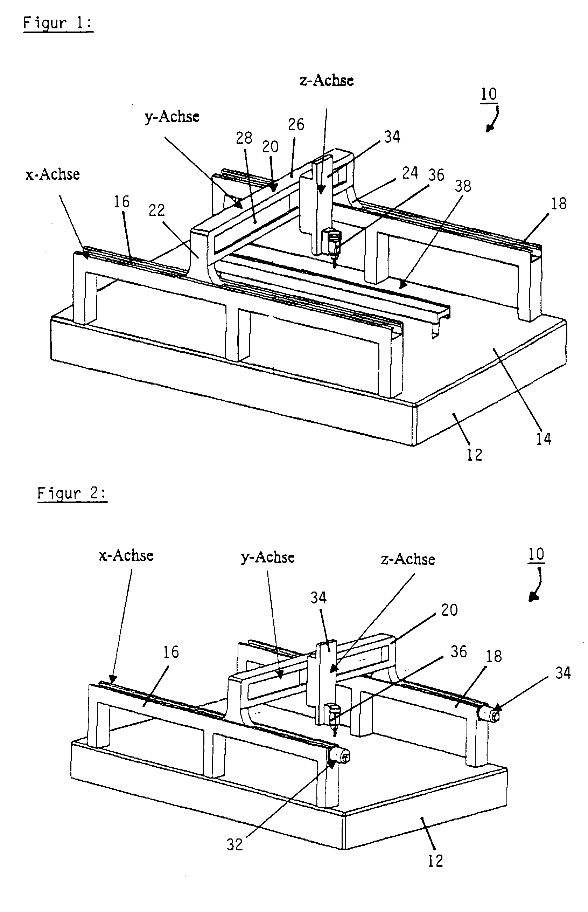

Figur 1 zeigt eine erste Ausführungsform einer Montagevorrichtung 10, insbesondere zur Verwendung als vollautomatische Montagevorrichtung zur Herstellung mikrosystemtechnischer Produkte sowie die Ausführung von Montageaufgaben in der Halbleiterindustrie. Die Montagevorrichtung 10 weist einen Montagetisch 12 mit einer Montageebene beziehungsweise Tischebene 14 auf. Auf der Tischebene 14 ist ein Transportsystem 16, 18 angeordnet. Das Transportsystem 16, 18 besteht aus einem Schienensystem mit zwei parallel angeordneten Schienen 16, 18. Des weiteren erkennt man, daß die Schienen 16, 18 über der Tischbeziehungsweise Montageebene 14 des Montagetisches 12 angeordnet sind. Es ist aber auch möglich, dieses Transportsystem 16, 18 in der Tischebene, d. h. auf dem Montagetisch, anzuordnen oder das Transportsystem 16 , 18 direkt an das Maschinengrundgestell anzulenken, um eine optimierte Karfteinleitung auf tragende Maschinenteile zu erreichen.

Mittels des Transportsystems 16, 18 wird ein Portal 20 bewegt. Das Portal 20 besteht dabei aus einer ersten und einer zweiten Portalstütze 22, 24, die jeweils in die Schienen 16, 18 eingreifen und dort geführt sind. Die beiden Portalstützen 22, 24 sind mittels eines Portalträgers 26 miteinander verbunden. Der Portalträger 26 weist in seiner Längsrichtung eine längliche Eingriffsöffnung 28 auf, in die eine Bauteiltransporteinheit 34 eingreift und bewegbar geführt ist. An der Bauteiltransporteinheit 34 ist ein Montagekopf 36 beweglich und lösbar befestigt.

Man erkennt, daß das Portal 20 parallel zur Richtung des Bauteiltransports verfahrbar ist. Der Bauteiltransport erfolgt dabei mittels eines Material-Transportsystems 38, das ebenfalls im Bereich der Montage- beziehungsweise Tischebene 14 angeordnet ist.

Es wird deutlich, daß die Ausrichtung des Transportsystems 16, 18 die x-Achse, der senkrecht dazu ausgerichtete Portalträger 26 des Portals 20 die y-Achse und die zur y-Achse vertikale Bewegungsrichtung der Bauteiltransporteinheit 34 beziehungsweise des Montagekopfes 36 die z-Achse der räumlichen Anordnung der Montagevorrichtung 10 bilden. Dabei kann in Richtung der z-Achse entweder die gesamte Bauteiltransporteinheit 34 oder lediglich der Montagekopf 36 auf der Bauteiltransporteinheit 34 bewegt werden.

Figur 2 zeigt die Montagevorrichtung 10 gemäß Figur 1. Man erkennt zusätzlich die Anordnung eines ersten und zweiten Portalantriebs 30, 32, die jeweils in einer Schiene 16 beziehungsweise 18 des Transportsystems angeordnet sind.

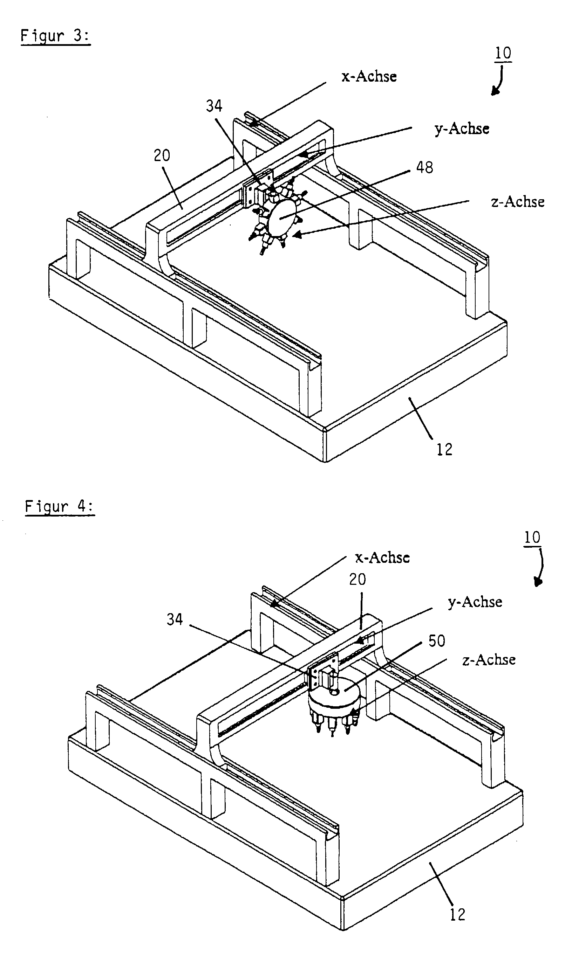

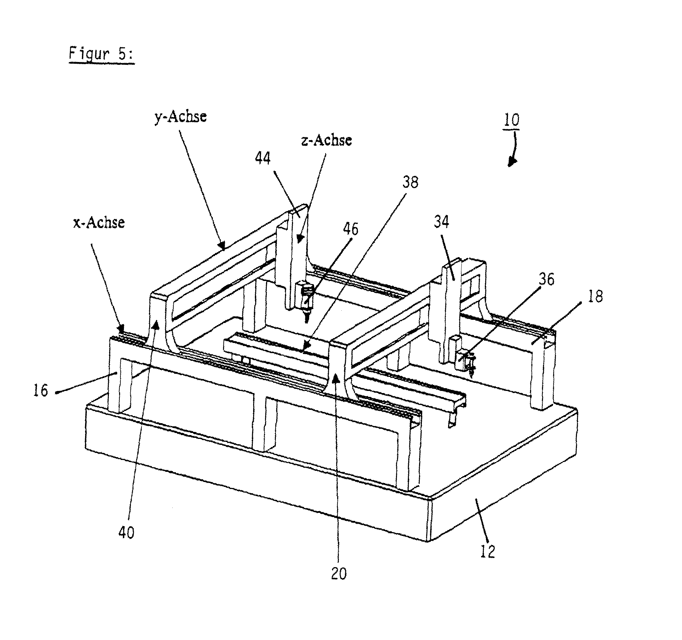

Die Figuren 3 und 4 zeigen jeweils weitere Ausführungsformen der Montagevorrichtung 10. Dabei ist der Montagekopf durch einen vertikal beziehungsweise horizontal angeordneten Revolverkopf 48, 50 ersetzt. Dabei bedeutet vertikale beziehungsweise horizontale Anordnung der Revolverköpfe 48, 50 die vertikale beziehungsweise horizontale Drehung der Revolverköpfe 48, 50 in Bezug auf die Montage- beziehungsweise Tischebene 14.

Figur 5 zeigt eine weitere Ausführungsform der Montagevorrichtung 10 mit zwei hintereinander angeordneten und verfahrbaren Portalen 20, 40. Die Bewegung der Portale 20, 40 ist dabei untereinander synchronisierbar. Es ist möglich, für die beiden Portale 20, 40 jeweils separate Portalantriebe oder auch einen gemeinsamen Portalantrieb vorzusehen. Des weiteren ist es möglich, daß die Portale 20, 40 eine unterschiedliche Höhe aufweisen, so daß unterschiedliche Montageebenen entstehen. Das dargestellte Ausführungsbeispiel zeigt allerdings eine Montagevorrichtung 10 mit zwei gleich ausgebildeten Portalen 20, 40.

## Patentansprüche

1. Montagevorrichtung, insbesondere vollautomatische Montagevorrichtung zur Herstellung mikrosystemtechnischer Produkte sowie für Montageaufgaben in der Halbleiterindustrie, mit einem Montagetisch (12), mindestens einem Materialtransportsystem (38) zum Transport der mit Bauteilen zu bestückenden Produkte, mindestens einem auf dem Montagetisch (12) angeordneten Transportsystem (16, 18) sowie mindestens eine zwischen dem Transportsystem (16, 18) angeordnete und bewegbare Bauteiltransporteinheit (34) mit mindestens einem Montagekopf (36),
**dadurch gekennzeichnet,**
daß die Bauteiltransporteinheit bzw. -einheiten (34, 44) auf einem oder mehreren, mittels des Transportsystems (16, 18) parallel zur Richtung des Bauteiltransports verfahrbaren Portalen (20, 40) angeordnet sind.

2. Montagevorrichtung nach Anspruch 1,
**dadurch gekennzeichnet,**
daß Transportsystem (16, 18) aus einem Schienensystem mit einer ersten Schiene (16) und einer zweiten Schiene (18) besteht, die zueinander parallel angeordnet sind.

3. Montagevorrichtung nach Anspruch 1 oder 2,
**dadurch gekennzeichnet,**
daß das Transportsystem (16, 18) mindestens einen Portalantrieb (30, 32) aufweist.

4. Montagevorrichtung nach einem der vorhergehenden Ansprüche,
**dadurch gekennzeichnet,**
daß das Transportsystem (16, 18) in der Tischebene (14) des Montagetisches (12) angeordnet ist.

5. Montagevorrichtung nach einem der Ansprüche 1 bis 3,
**dadurch gekennzeichnet,**
daß das Transportsystem (16, 18) über der Tischebene (14) des Montagetisches (12) angeordnet ist.

6. Montagevorrichtung nach einem der vorhergehenden Ansprüche,
**dadurch gekennzeichnet,**
daß die Ausrichtung des Transportssystems die x-Achse, ein senkrecht dazu ausgerichteter Portalträger (26, 42) des Portals (20, 40) die y-Achse und eine zur y-Achse vertikale Bewegungsrichtung der Bauteiltransporteinheit (34, 44) bzw. des Montagekopfs (36, 46) die z-Achse der räumlichen Anordnung der Montagevorrichtung (10) bilden.

7. Montagevorrichtung nach einem der vorhergehenden Ansprüche,
**dadurch gekennzeichnet,**
daß die Bewegungungen mehrerer Portale (20, 40) untereinnder synchronisierbar sind.

8. Montagevorrichtung nach einem der vorhergehenden Ansprüche,
**dadurch gekennzeichnet,**
daß der Montagekopf (36, 46) aus einem vertikal oder horizontal angeordneten Revolverkopf (48, 50) besteht.

9. Montagevorrichtung nach einem der vorhergehenden Ansprüche,
**dadurch gekennzeichnet,**
daß mehrere Portale übereinander angeordnet sind.
